Europäisches Patentamt

European Patent Office

Office européen des brevets

(11) Numéro de publication: **0 502 790 B1**

# FASCICULE DE BREVET EUROPEEN

(45) Date de publication de fascicule du brevet: **14.12.94**  (51) Int. Cl.5: **C23C 28/04**, C23C 16/34, C23C 16/40, G02B 1/10

(21) Numéro de dépôt: **92400581.2**

(22) Date de dépôt: **06.03.92**

(54) **Revêtement multicouche pour substrat polycarbonate.**

(30) Priorité: **06.03.91 FR 9102662**

(43) Date de publication de la demande:
**09.09.92 Bulletin 92/37**

(45) Mention de la délivrance du brevet:
**14.12.94 Bulletin 94/50**

(84) Etats contractants désignés:
**BE CH DE ES GB IT LI NL SE**

(56) Documents cités:
**EP-A- 0 185 189**
**EP-A- 0 284 693**
**US-A- 4 609 267**

(73) Titulaire: **L'AIR LIOUIDE, SOCIETE ANONYME POUR L'ETUDE ET L'EXPLOITATION DES PROCEDES GEORGES CLAUDE**
**75, Ouai d'Orsay**
**F-75321 Paris Cédex 07 (FR)**

(72) Inventeur: **Rostaing, Jean-Christophe**
**23 rue Ardy**
**F-78000 Versailles (FR)**
Inventeur: **Coeuret, François**
**63 boulevard Beethoven,**
**Résidence les Symphonies**
**F-78280 Guyancourt (FR)**

(74) Mandataire: **Le Moenner, Gabriel et al**
**L'AIR LIOUIDE, Société Anonyme**
**pour l'étude et l'exploitation des procédés**
**Georges Claude**
**75, Ouai d'Orsay**
**F-75321 Paris Cédex 07 (FR)**

**Description**

La présente invention concerne un revêtement multicouche pour substrat polycarbonate utilisé à titre de succédané du verre, ou autres matériaux polymériques transparents qui ont actuellement tendance à remplacer le verre pour diverses applications telles les glaces de phares d'automobiles, les verres de lunettes, etc.. Parmi ceux-ci, le polycarbonate est particulièrement apprécié, notamment pour son excellente tenue aux chocs. Cependant, l'usage de ce matériau est limité par sa mauvaise tenue à la rayure et au vieillissement accéléré qu'il subit sous l'effet du rayonnement ultra-violet naturel. Il est donc nécessaire de protéger le polycarbonate au moins contre ces deux facteurs de dégradation, étant entendu que d'autres exigences fonctionnelles peuvent être avancées en fonction d'une application particulière.

Actuellement, les revêtements protecteurs pour polycarbonate disponibles commercialement sont des vernis acryliques, organosilicones ou polysiloxanes appliqués par pulvérisation ou trempage, éventuellement séchés par UV. On envisage de remplacer ces revêtements par des alliages amorphes de silicium déposés à température ambiante par PECVD ("Plasma enhanced chemical vapor deposition") à partir de silane. Un tel procédé est par exemple décrit dans les brevets FR-2.614.317 et FR-2.631.346. L'un des problèmes majeurs à résoudre est d'assurer une bonne tenue du revêtement aux variations importantes de température, compte tenu de la disproportion des coefficients de dilatation de la couche et du substrat, alors qu'on impose à ces produits des spécifications sévères sur la tenue aux cyclages et aux chocs thermiques.

Dans le brevet FR-A-2661688 au nom de la Demanderesse, on propose la réalisation d'un revêtement anti-UV de type absorptif, utilisant un alliage amorphe de silicium déposé par PECVD à partir de silane, dont le seuil de coupure est ajusté via la composition en choisissant des valeurs appropriées des différents débits gazeux. Si une amélioration de la tenue au rayonnement ultra-violet (UV) est effectivement observée pour des densités de rayonnement modérées (lampe UV de laboratoire), les revêtements réalisés ne passent pas en général les tests accélérés sous très forte intensité recommandés par les organismes de normalisation.

Ce comportement peut être expliqué si l'on considère la variation du coefficient d'absorption dans les semiconducteurs et les isolants amorphes. A basse énergie, l'absorption résulte de transitions entre états localisés de la bande interdite. Elle est très peu intense et la région spectrale correspondante est considérée comme transparente. A moyenne énergie, l'absorption résulte de transitions entre états localisés en bord de bande de valence et de conduction, qui résultent de la structure partiellement désordonnée du matériau, et états étendus de la bande opposée. La forme expérimentale du coefficient d'absorption dans cette zone appelée "queue d'Urbach" semble bien décrite par une loi du type :

$\alpha = \alpha_0 \exp ( (h\nu - E_1) / E_0 )$ où $\alpha_0$ et $E_1$ sont indépendants du désordre. $E_0$ mesure l' "extension" de la queue d'Urbach et constitue une mesure indirecte du désordre de structure.

A haute énergie enfin, l'absorption résulte de transitions électroniques entre états étendus de bande à bande. Elle est couramment décrite par la loi de Tauc :

$$( \alpha h\nu)^{1/2} = B ( H - E_G).$$

Le paramètre B est représentatif de la "vitesse de variation" de $\alpha$ à haute énergie, tandis que $E_G$ définit le seuil en énergie du photon, au-delà duquel le matériau peut être considéré comme totalement opaque. Par analogie avec les solides cristallins, $E_G$ est appelé largeur de bande interdite optique ("gap" optique).

Pour réaliser un filtre UV absorptif, on dépose un alliage amorphe de silicium dont le "gap" optique soit voisin de la limite entre le visible et l'ultra-violet. Le filtre idéal devrait présenter un profil en forme de marche de façon à stopper la totalité du rayonnement UV tout en étant parfaitement transparent dans le visible. Il est loin d'en être ainsi en pratique.

Si l'on considère le coefficient de transmission expérimental d'une couche d'un alliage a-SiN$_y$:H dont le "gap" est voisin de 350 nm, d'épaisseur 1 $\mu$m environ, en fonction de la longueur d'onde, on retrouve trois zones caractéristiques des différents comportements de l'absorption, mentionnés précédemment : quasi transparence, queue d'Urbach, forte absorption "parabolique". La transition entre quasi-transparence et transmission quasi nulle présente une plage en longueur d'onde qui est loin d'être négligeable. Si cette région est centrée sur la limite UV/visible (vers 350 nm), certaines longueurs d'onde du visible (violet-bleu) sont atténuées notablement, donnant lieu à une coloration jaunâtre de l'échantillon, alors qu'une partie du spectre UV est transmise, en particulier autour de 365 nm, longueur d'onde très nuisible pour le polycarbonate. Si l'on utilise un matériau de plus faible "gap", en sorte de rendre la transmission quasi nulle dans tout le domaine UV, le film apparaîtra jaune orangé foncé puis brunâtre (couleur caractéristique du silicium amorphe). On connaît peu d'applications où cette caractéristique serait admissible. On ne peut d'autre part espérer agir sur les propriétés optiques du matériau pour réduire la largeur de la transmission entre faible et forte absorption, c'est-à-dire augmenter le préfacteur B de la loi de Tauc et réduire le paramètre $E_0$. En effet, il semble que B et $E_0$ soient, au premier ordre, fonction uniquement de l'incorporation relative d'oxygène, azote, hydrogène par rapport au silicium, laquelle est imposée par le choix de la valeur du "gap" optique.

Une autre solution théorique serait de renforcer la pente de la coupure en augmentant l'épaisseur de matériau absorbant déposé, la transmission variant dans la zone de forte absorption comme $\alpha$ (n,k) $e^{-\alpha d}$ où $\alpha$ est une fonction rationnelle. La simulation montre que les épaisseurs nécessaires seraient de plusieurs microns, ce qui est tout à fait irréaliste à la fois technologiquement et économiquement. En effet, les spécifications thermomécaniques sont d'autant plus difficiles à tenir que l'épaisseur des couches est élevée. D'autre part, la couche absorbante est formée d'un matériau sous-stoechiométrique de médiocre dureté et doit être associée à une couche structurelle dure distincte, de plusieurs microns également. L'épaisseur cumulée de matériau, et de ce fait le temps de réalisation du film, s'en trouveraient excessivement allongés.

Jusqu'ici, la fonction anti-UV sur polycarbonate a été réalisée uniquement pour des revêtements déposés par voie liquide. Une molécule absorbante appropriée est incorporée au produit à appliquer. Il peut s'agir, selon le cas, du primaire d'adhérence seulement (épaisseur 1 $\mu$m environ) ou de l'ensemble du revêtement (épaisseur 5 $\mu$m environ). Il apparaît que les résultats aux tests ne sont satisfaisants que dans ce dernier cas.

Les revêtements déposés par PECVD nécessitent généralement un primaire d'adhérence liquide qui assure également la fonction anti-UV, avec les restrictions qui viennent d'être mentionnées. Il n'y a pas d'analogue connu en PECVD aux molécules absorbantes dans l'UV employées dans le cas des vernis. La nécessité d'adjoindre de toutes manières une couche appliquée par voie liquide au procédé PECVD condamnerait ce dernier sur le plan économique.

Un autre facteur très important à prendre en compte est celui de la tenue thermomécanique du filtre anti-UV lui-même. Dans le brevet FR-A-2661688, on décrit la réalisation de filtres UV absorptifs à partir de matériaux oxydes, oxynitrures et nitrures de silicium hydrogénés faiblement carburés. Pour certaines applications, des tests accélérés très sévères sont imposés, comme l'exposition à la lampe à arc Xenon ( $\approx$ O,1 W/cm$^2$) pendant 2000 h. Or on a mis en évidence une dégradation très rapide des matériaux oxyde et oxynitrure lors de ce test, avec ouverture du "gap" optique et perte des propriétés d'absorption sélective. Seul le matériau dit "nitrure", c'est-à-dire déposé uniquement à partir de silane et d'azote, n'est pas dégradé par le test accéléré.

Cependant, ce matériau présente par ailleurs un inconvénient très sérieux, à savoir sa médiocre tenue thermomécanique. Si l'on réalise la structure suivante selon le procédé décrit dans le FR-2.631.346, à savoir : activation du polycarbonate, couche d'adhésion à Si:H, couche anti-UV SiN$_y$:H, couche dure SiO$_2$:H, l'échantillon obtenu ne résiste pas aux tests de cyclages thermiques classiques.

Etant donné la bonne tenue thermomécanique des couches de silice, on a réalisé des échantillons où une couche de SiO$_2$:H est insérée entre la couche d'adhésion et la couche anti-UV SiN$_y$:H. L'expérience montre qu'une amélioration significative des propriétés thermomécaniques n'est obtenue qu'avec une couche intermédiaire de silice d'épaisseur prohibitive. Les performances sont d'ailleurs encore insuffisantes vis-à-vis du cahier des charges de certains utilisateurs.

La présente invention vise un revêtement pour substrat du type polycarbonate réalisant à la fois un seuil de transmission abrupt à la limite UV/visible et de faire en sorte que les échantillons de polycarbonate ainsi revêtus du filtre anti-UV et d'une couche structurelle dure soient résistants aux cyclages et aux chocs thermiques, et ces objectifs de l'invention sont atteints par une structure composite du revêtement combinant un système interférentiel à fenêtre de réflectance s'étendant sur une faible plage de longueurs d'onde à partir de la frontière inférieure du domaine visible vers les longueurs d'onde plus faibles de l'ultra-violet d'une part, et un système absorptif dont la plage de longueurs d'onde de transition du domaine d'absorption au domaine de transparence se situe dans la fenêtre de réflectance du système interférentiel.

Comme il s'est donc avéré que l'utilisation du concept d'absorption seul ne permet pas d'obtenir une coupure suffisamment abrupte, on s'est reporté sur un système interférentiel, qui n'est généralement pas envisagé pour ce type d'application, parce qu'il est difficile dans un procédé PECVD de contrôler dans des limites étroites (quelques %) l'épaisseur et l'indice des couches sur toute la surface d'un article en matière plastique, surtout s'il est de forme gauche. Mais, en réalité, cette difficulté se présente de la même manière pour un filtre absorptif, où la position du seuil de transmission est très sensible à la composition du matériau.

Pour réaliser un filtre interférentiel, on empile des couches alternées de deux matériaux, l'un dit de haut indice $n_H$ et l'autre de bas indice $n_B$, les épaisseurs de couches $d_H$ et $d_{Ba}$ étant choisies de façon que

$$n_H d_H = (2k + 1) . \lambda_o / 4$$
$$n_B d_B = (2k' + 1) . \lambda_o / 4$$

où k et k' sont entiers; le filtre présentera un pic de réflectance autour de $\lambda_o$.

Pour élargir la bande de réflectance, il convient cependant d'empiler plusieurs filtres dont les pics de réjection sont adjacents.

Cependant, même dans le cas le plus favorable où k = k' = O, ces pics sont étroits et on ne peut augmenter arbitrairement le nombre de filtres. L'épaisseur cumulée de matériau peut devenir prohibitive vis-à-vis des propriétés thermomécaniques, du temps d'élaboration et aussi de la longueur de cohérence de la lumière naturelle, et la solution proposée par l'invention combine les concepts absorptif et interférentiel de la manière suivante :

- un certain nombre de filtres interférentiels sont empilés, de façon à obtenir une fenêtre de réflectance s'étendant dans l'ultra-violet à partir de la limite du domaine visible (vers 380 nm). Comme on a vu qu'il existe une limitation pratique au nombre de filtres, si l'on utilise des matériaux transparents dans l'UV, la transmission de la structure redevient de l'ordre de l'unité pour des longueurs d'ondes de l'ordre de 250 à 300 nm, dans un domaine où il existe plusieurs raies nuisibles pour le polycarbonate,
- cette remontée indésirable de la transmission est annulée par un dispositif absorptif dans le domaine spectral considéré, mais transparent dans le visible. Plus précisément, le matériau absorbant est choisi de manière que la limite de son domaine de transparence coïncide juste avec la coupure (ou fenêtre de réflectance) du dispositif interférentiel à la frontière du domaine visible, ou, en d'autres termes, que la plage de longueurs d'onde de la fenêtre des réflectances du système interférentiel recouvre substantiellement la plage de longueurs d'onde de transition du système absorptif,
- les deux fonctions peuvent être avantageusement assurées par le même ensemble de couches. A cet effet, on utilise comme matériau de bas indice une silice hydrogénée quasi stoechiomérique, a-SiO$_2$:H et comme matériau de haut indice un nitrure hydrogéné sous-stoechiométrique, a-SiN$_y$:H, absorbant dans l'UV, avec y de l'ordre de 1,2 à 1,5.

Il en résulte deux conséquences favorables supplémentaires du point de vue optique :

a) le matériau a-SiN$_y$:H présente un indice de réfraction plus élevé que le nitrure quasi stoechiométrique a-Si$_3$N$_4$:H, ce qui renforce l'efficacité du filtre interférentiel et permet de réduire le nombre de couches,

b) l'atténuation du rayonnement par absorption est renforcée par une augmentation du trajet net de l'onde du fait des réflexions multiples dans la multicouche alternée.

D'autre part, cette conception apporte en corollaire un autre avantage crucial du point de vue des propriétés thermomécaniques. On a vu en effet que a-SiN$_y$:H est le seul parmi les matériaux absorbants dont on dispose qui résiste aux tests accélérés de vieillissement aux UV, mais que ses propriétés thermomécaniques médiocres interdisent d'en envisager l'utilisation en couches d'épaisseur importante (de l'ordre de 1 $\mu$m). En revanche a-SiO$_2$:H présente de remarquables propriétés thermomécaniques. On envisage donc des structures où des couches de faible épaisseur de a-SiN$_y$:H alternent avec des couches de a-SiO$_2$:H de façon à répartir et absorber les contraintes. On solutionne ainsi au moins en partie les problèmes de thermomécanique, sous réserve que les épaisseurs de couche nécessaires soient compatibles avec celles imposées par la fonction optique. Celles-ci seront de 500 à 600 Å pour le nitrure et légèrement plus pour la silice.

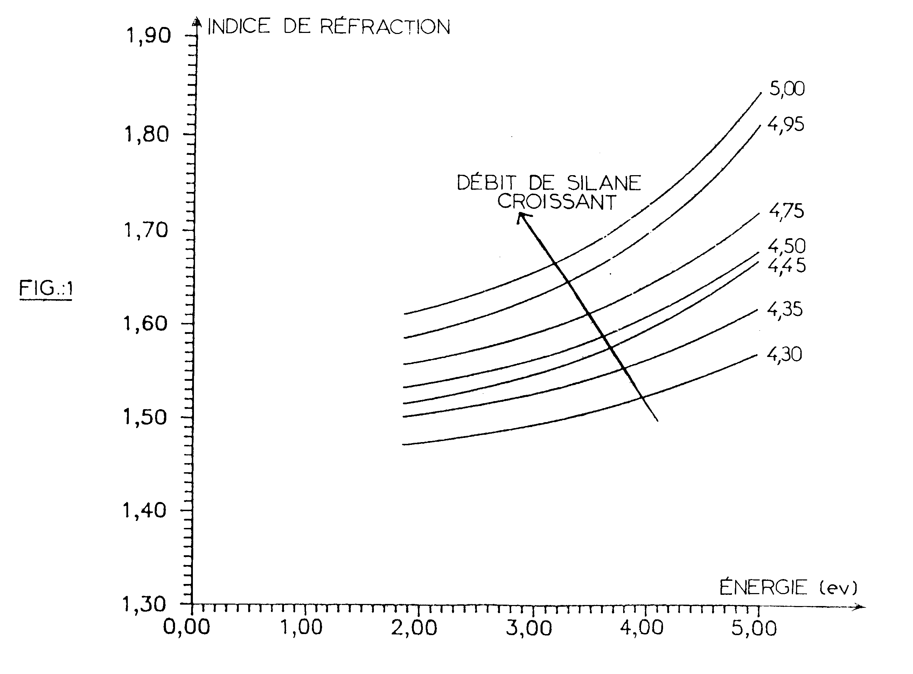

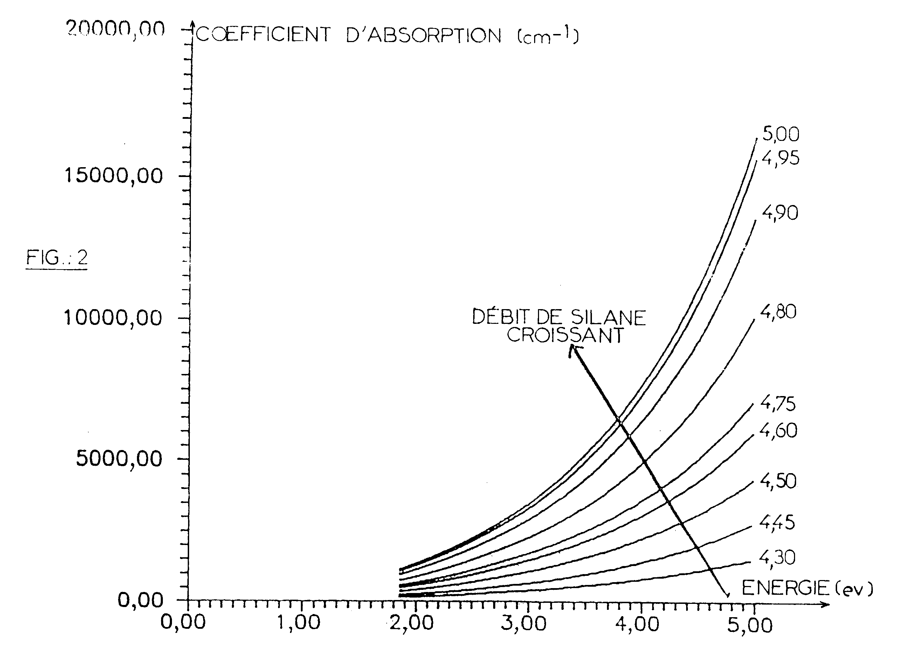

Une approche de mise en oeuvre de l'invention est maintenant décrite en référence aux figures 1 et 2 qui représentent respectivement des diagrammes d'indice de réfraction et de coefficient d'absorption en fonction de l'énergie (eV). Pour mettre au point un filtre anti-UV, on se guide sur la transmission du système constitué de ce filtre déposé sur un substrat transparent dans le domaine spectral considéré, en l'occurrence une lame de silice fondue. Ceci n'est pas exactement représentatif du problème posé, car la grandeur réellement significative est la densité spectrale d'énergie électromagnétique entrant dans un substrat de polycarbonate. Celle-ci peut différer sensiblement de l'énergie transmise par le système formé du filtre déposé sur un substrat transparent de quartz. Il existe d'ailleurs certaines difficultés pour accéder à l'énergie entrant effectivement dans un milieu absorbant tel que le polycarbonate dans l'UV, car la forme de l'onde électromagnétique y est complexe et n'y est plus représentée par les concepts classiques d'onde réfléchie et transmise. Mais on peut supposer raisonnablement que la transmission mesurée sur quartz est une bonne approche, au premier ordre, des caractéristiques fonctionnelles réelles du filtre. La mise au point définitive pourra alors être effectuée, le cas échéant, en comparant les comportements aux tests UV de plusieurs structures voisines.

La recherche d'une fonction de transmission appropriée en opérant sur des structures réelles s'avère extrêmement longue et fastidieuse sur un équipement de dépôt de simple laboratoire. Il est donc indiqué de disposer d'un outil de simulation consistant en une bibliothèque des spectres de constantes optiques des différents matériaux a-SiN$_y$:H accessibles par le procédé de dépôt, complété par un logiciel de calcul de la transmission d'une structure multicouche quelconque formée à partir de ces matériaux. On peut ainsi tester un grand nombre de configurations dans un temps raisonnable, distinguer les effets des différents paramètres de conception et optimiser une structure donnée.

Il y a lieu de se rappeler en particulier que les aspects absorptifs et interférentiels ne sont pas indépendants, dans la mesure où l'indice de réfraction des matériaux peut varier sensiblement dans une région d'absorption, obligeant à raffiner en conséquence la conception du filtre.

Les constantes optiques (n, k) des matériaux sont déterminées sur la gamme de longueurs d'ondes d'intérêt par tout moyen expérimental approprié. On a choisi l'ellipsométrie spectroscopique qui livre des résultats d'une précision tout à fait acceptable pour la présente application.

Les résultats sont rassemblés sur les figures 1 et 2.

On constate en particulier que les indices de réfraction (figure 1) restent étonnamment faibles. La fiabilité de ces valeurs a été vérifiée par ailleurs et il semble, en accord avec les résultats de la littérature, que ces matériaux déposés à température quasi ambiante soient plutôt des diimides que des nitrures.

A partir de ces spectres de $\underline{n}$ et $\underline{k}$, une structure répondant aux spécifications optiques précédemment énoncées a été conçue par raffinements successifs dont la composition est la suivante :

| | | |
|---|---|---|
| SiO$_2$:H | 1000 Å | |
| SiN$_{y1}$:H | 390 Å | |
| SiO$_2$:H | 530 Å | ) |
| SiN$_{y1}$:H | 390 Å | ) x 2 couches |
| SiO$_2$:H | 620 Å | ) |
| SiN$_{y1}$:H | 480 Å | ) x 6 couches |
| SiO$_2$:H | 700 Å | ) |
| SiN$_{y1}$:H | 560 Å | ) x 6 couches |
| SiO$_2$:H | 740 Å | ) |
| SiN$_{y2}$:H | 620 Å | ) x 6 couches |
| SiO$_2$:H | 3,0 μm | |

dans laquelle SiN$_{y1}$:H et SiN$_{y2}$:H désignent les matériaux nitrures déposés avec des débits de silane de 4,50 et 4,30 sccm, respectivement.

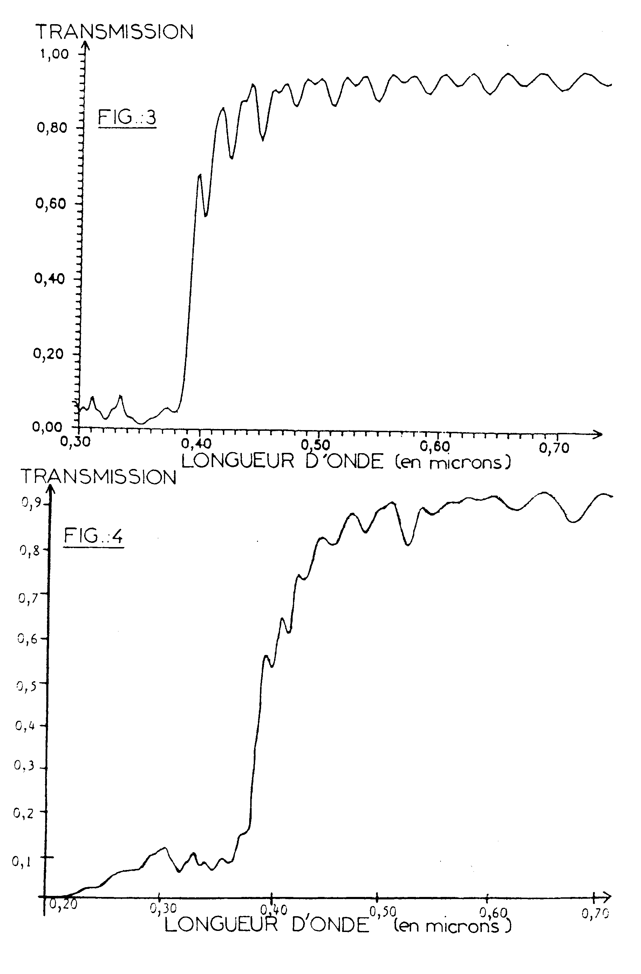

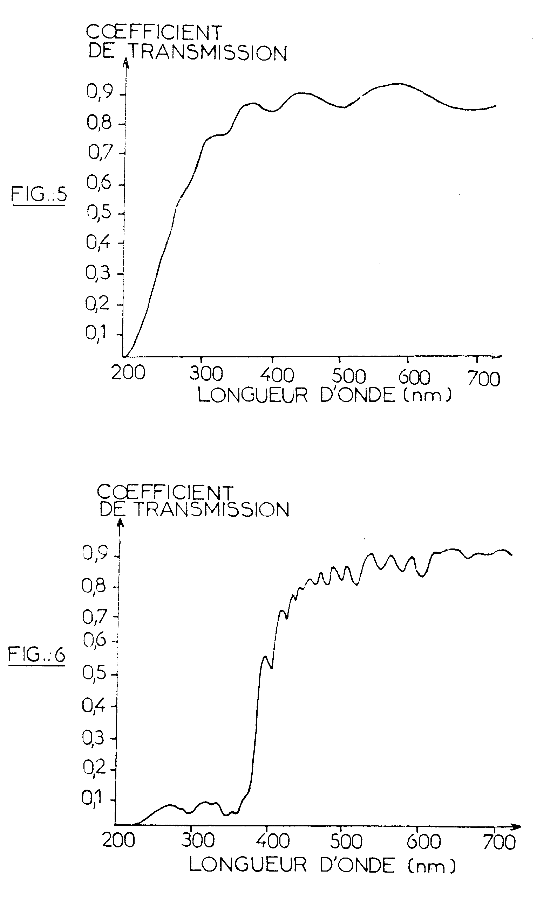

La transmission calculée pour cette structure à partir des constantes optiques des matériaux entrant dans sa composition, est représentée à la figure 3 en même temps que la transmission mesurée sur la multicouche réelle déposée sur quartz (figure 4) et l'on a représenté aux figures 5 et 6 le coefficient de transmission d'une monocouche de a-SiN$_y$:H de 1 μm environ (figure 5) et de la multicouche selon l'invention (figure 6).

On note les améliorations suivantes :

- l'extension de la zone de transition entre transparence et transmission quasi nulle a été très fortement réduite,
- le coefficient de transmission à 365 nm, longueur d'onde particulièrement nuisible pour le polycarbonate, est inférieur à 0,1,
- la remontée du coefficient de transmission dans l'UV est très fortement atténuée par rapport à un filtre interférentiel pur.

Des tests préliminaires à l'aide de lampes spectrales UV de laboratoire ont donné les résultats suivants pour des échantillons de polycarbonate revêtus de la structure précédente :

- pas de modification décelable de l'échantillon après 4000 h d'exposition à 365 nm (sur l'échantillon non protégé, le film dur SiO$_x$ délamine après 20 h),

- pas de jaunissement visible après 500 h à 254 nm (l'échantillon témoin non revêtu est nettement jaune).

Sur le plan des propriétés thermomécaniques, une amélioration très nette a été observée par rapport aux filtres monocouche de $SiN_y$:H. Un échantillon a été réalisé en déposant sur substrat un polycarbonate préalablement activé, la couche d'adhésion, le filtre anti-UV et une couche dure $SiO_2$:H de 3 $\mu$m, selon le procédé de l'invention. Cet échantillon résiste à 10 cycles thermiques - 40 à + 80°C en atmosphère sèche et 10 cycles identiques en atmosphère saturée d'humidité.

Les applications de l'invention sont celles où le polycarbonate transparent doit être protégé du vieillissement induit par les UV en plus du revêtement dur anti-abrasion, et spécialement quand on impose des tests accélérés sévères de tenue aux UV et des exigences également sévères sur les propriétés thermomécaniques, par exemple les glaces de phares d'automobiles et les verres de lunettes.

Le concept de l'invention est généralisable à tous les cas où est nécessaire un filtre optique à large bande ou passe-bas à coupure abrupte, celle-ci pouvant être largement déplacée dans le domaine UV/visible en jouant sur les épaisseurs et les compositions des couches d'alliages amorphes de silicium via les valeurs des paramètres de dépôt. Différents alliages amorphes de silicium (oxydes, nitrures, carbures..) peuvent être utilisés en fonction des impératifs fonctionnels requis par ailleurs, la composition de ces alliages étant aisément contrôlable sur une large plage dans un procédé PECVD silane.

**Revendications**

1. Revêtement multicouche pour substrat polycarbonate utilisé à titre de succédané du verre, comportant essentiellement du silicium, de l'oxygène ou de l'azote, et de l'hydrogène selon la formule

    $SiO_2$ : H
    $SiN_y$ : H

    caractérisé par une structure composite du revêtement combinant un système interférentiel à fenêtre de réflectance s'étendant sur une faible plage de longueurs d'onde à partir de la frontière inférieure du domaine visible vers les longueurs d'onde plus faibles de l'ultraviolet d'une part, et un système absorptif dont la plage de longueurs d'onde de transition du domaine d'absorption au domaine de transparence se situe dans la fenêtre de réflectance du système interférentiel.

2. Revêtement multicouche pour substrat polycarbonate selon la revendication 1, caractérisé en ce que la plage de longueurs d'onde de la fenêtre de réflectance du système interférentiel est substantiellement au moins égale à la plage de longueurs d'onde de transition du système absorptif.

3. Revêtement multicouche pour substrat polycarbonate selon la revendication 1 ou 2, caractérisé en ce que le système de revêtement interférentiel met en oeuvre comme matériau de bas indice une silice hydrogénée quasi stoechiométrique a-$SiO_2$ : H et comme matériau de haut indice un nitrure hydrogéné sous-stoechiométrique a-$SiN_y$ : H, avec "y" de l'ordre de 1,2 à 1,5, ce dernier matériau formant simultanément le système absorptif.

4. Revêtement multicouche pour substrat polycarbonate selon la revendication 1,caractérisé par la structure de couche suivant, à partir du substrat polycarbonate :

$$SiO_2 : H \qquad 1000 \text{ Å}$$
$$SiN_{y1} : H \qquad 390 \text{ Å}$$

| | | |
|---|---|---|
| $SiO_2$ : H | 530 Å | ) |
| $SiN_{y1}$ : H | 390 Å | ) x 2 couches |
| $SiO_2$ : H | 620 Å | ) |
| $SiN_{y1}$ : H | 480 Å | ) x 6 couches |
| $SiO_2$ : H | 700 Å | ) |
| $SiN_{y1}$ : H | 560 Å | ) x 6 couches |
| $SiO_2$ : H | 740 Å | ) |
| $SiN_{y2}$ : H | 620 Å | ) x 6 couches |
| $SiO_2$ : H | 3,0 µm | |

dans laquelle $SiN_{y1}$ : H et $SiN_{y2}$ : H désignent les matériaux nitrures déposés avec des débits de silane de 4,50 et 4,30 sccm, respectivement.

## Claims

1. Multilayer coating for a polycarbonate substrate used as a substitute for glass, comprising essentially silicon, oxygen or nitrogen, and hydrogen according to the formula

   $SiO_2$ : H
   $SiN_y$ : H

   characterised by a composite structure of the coating combining an interference system with a reflectance window extending over a small range of wavelengths from the lower boundary of the visible region to the shorter wavelengths of the ultraviolet region on the one hand, and an absorption system in which the range of transition wavelengths from the absorption region to the transparency region is situated within the reflectance window of the interference system.

2. Multilayer coating for a polycarbonate substrate according to Claim 1, characterised in that the range of wavelengths of the reflectance window of the interference system is substantially at least equal to the range of transition wavelengths of the absorption system.

3. Multilayer coating for a polycarbonate substrate according to Claim 1 or 2, characterised in that the interference coating system uses, as a low-index material, a quasi-stoichiometric hydrogenated silica a-$SiO_2$ : H and, as a high-index material, a sub-stoichiometric hydrogenated nitride a-$SiN_y$ : H, where "y" is around 1.2 to 1.5, the latter material simultaneously forming the absorption system.

4. Multilayer coating for a polycarbonate substrate according to Claim 1, characterised by the following layer structure, starting from the polycarbonate substrate:

| | | |
|---|---|---|
| SiO$_2$ : H | 1000 Å | |
| SiN$_{y1}$ : H | 390 Å | |
| SiO$_2$ : H | 530 Å | ) |
| SiN$_{y1}$ : H | 390 Å | ) x 2 layers<br>) |
| SiO$_2$ : H | 620 Å | ) |
| SiN$_{y1}$ : H | 480 Å | ) x 6 layers<br>) |
| SiO$_2$ : H | 700 Å | ) |
| SiN$_{y1}$ : H | 560 Å | ) x 6 layers<br>) |
| SiO$_2$ : H | 740 Å | ) |
| SiN$_{y2}$ : H | 620 Å | ) x 6 layers<br>) |
| SiO$_2$ : H | 3.0 $\mu$m | |

in which SiN$_{y1}$ : H and SiN$_{y2}$ : H designates the nitride materials deposited with silane flow rates of 4.50 and 4.30 sccm respectively.

**Patentansprüche**

1. Mehrlagiger Überzug für ein Polycarbonatsubstrat, das als Glasersatz verwendet wird, wobei der Überzug im wesentlichen Silicium, Sauerstoff oder Stickstoff und Wasserstoff gemäß folgender Formel umfaßt:

   SiO$_2$ : H
   SiN$_y$ : H

   gekennzeichnet durch eine Überzugsverbundstruktur, die ein Interferenzsystem mit einem Reflexionsfenster umfaßt, das sich über einen schmalen Wellenlängenbereich von der unteren Grenze des sichtbaren Lichtes bis zu den kürzesten ultravioletten Wellenlängen erstreckt, kombiniert mit einem Absorptionssystem, dessen Wellenlängenbereich des Übergangs von der Absorption zur Lichtdurchlässigkeit in dem Reflexionsfenster des Interferenzsystems liegt.

2. Mehrlagiger Überzug für ein Polycarbonatsubstrat nach Anspruch 1, dadurch gekennzeichnet, daß der Wellenlängenbereich des Reflexionsfensters des Interferenzsystems zumindest im wesentlichen gleich dem des Absorptionsübergangswellenlängenbereichs ist.

3. Mehrlagiger Überzug für ein Polycarbonatsubstrat nach Anspruch 1 oder 2, dadurch gekennzeichnet, daß das Interferenzüberzugsystem als Brechungsindex-Basismaterial ein quasistöchiometrisches wasserstoffhaltiges Silikat a-SiO$_2$ : H und als Material mit großem Brechungsindex ein unterstöchiometrisches wasserstoffhaltiges Nitrid a-SiN$_y$ : H enthält, wobei "y" in der Größenordnung von 1,2 bis 1,5 liegt, und wobei das zuletzt genannte Material gleichzeitig das Absorptionssystem bildet.

4. Mehrlagiger Überzug für ein Polycarbonatsubstrat nach Anspruch 1, gekennzeichnet durch folgende, auf das Polycarbonatsubstrat folgende Schichtstruktur:

| | | |
|---|---|---|
| SiO$_2$ : H | 1000 A | |
| SiN$_{y1}$ : H | 390 A | |
| SiO$_2$ : H | 530 A | ) |
| | | x 2 Lagen |
| SiN$_{y1}$ : H | 390 A | ) |
| SiO$_2$ : H | 620 A | ) |
| | | x 6 Lagen |
| SiN$_{y1}$ : H | 480 A | ) |
| SiO$_2$ : H | 700 A | ) |
| | | x 6 Lagen |
| SiN$_{y1}$ : H | 560 A | ) |
| SiO$_2$ : H | 740 A | ) |
| | | x 6 Lagen |
| SiN$_{y2}$ : H | 620 A | ) |
| SiO$_2$ : H | 3,0 $\mu$m | |

wobei SiN$_{y1}$ : H und SiN$_{yy2}$ : H die Nitridmaterialien bezeichnen, die mit Silanmengen von 4,50 und 4,30 sccm niedergeschlagen sind.

FIG.1

FIG.: 2

EP 0 502 790 B1

TRANSMISSION

FIG.:3

LONGUEUR D'ONDE (en microns)

TRANSMISSION

FIG.:4

LONGUEUR D'ONDE (en microns)

CŒFFICIENT DE TRANSMISSION

FIG.:5

LONGUEUR D'ONDE (nm)

CŒFFICIENT DE TRANSMISSION

FIG.:6

LONGUEUR D'ONDE (nm)